(19) Europäisches Patentamt
European Patent Office
Office européen des brevets

(11) EP 4 498 403 A1

(12) EUROPEAN PATENT APPLICATION
published in accordance with Art. 153(4) EPC

(43) Date of publication:
**29.01.2025 Bulletin 2025/05**

(21) Application number: **23774527.8**

(22) Date of filing: **08.03.2023**

(51) International Patent Classification (IPC):
***H01L 21/304*** *(2006.01)* ***C08K 3/36*** *(2006.01)*
***C08L 1/08*** *(2006.01)* ***C08L 29/04*** *(2006.01)*
***C08L 33/26*** *(2006.01)* ***C09G 1/02*** *(2006.01)*
***C09K 3/14*** *(2006.01)*

(52) Cooperative Patent Classification (CPC):
**C08K 3/36; C08L 1/08; C08L 29/04; C08L 33/26; C09G 1/02; C09K 3/14; H01L 21/304**

(86) International application number:
**PCT/JP2023/008722**

(87) International publication number:
**WO 2023/181928 (28.09.2023 Gazette 2023/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **23.03.2022 JP 2022047438**

(71) Applicant: **Fujimi Incorporated**
**Kiyosu-shi, Aichi 452-8502 (JP)**

(72) Inventors:
- **GOTO, Osamu**
  **Kiyosu-shi, Aichi 452-8502 (JP)**
- **TANAKA, Yuki**
  **Kiyosu-shi, Aichi 452-8502 (JP)**
- **TSUCHIYA, Kohsuke**
  **Kiyosu-shi, Aichi 452-8502 (JP)**

(74) Representative: **Grünecker Patent- und Rechtsanwälte**
**PartG mbB**
**Leopoldstraße 4**
**80802 München (DE)**

# (54) POLISHING COMPOSITION

(57) Provided is a polishing composition that allows production of a high surface quality and can enhance a polishing removal rate. Provided is a polishing composition that contains silica particles as an abrasive, a basic compound, water, a cellulose derivative as a first water-soluble polymer, a polyvinyl alcohol-based polymer as a second water-soluble polymer, and a nitrogen atom-containing polymer as a third water-soluble polymer. In the polishing composition, the ratio (C1/(C2 + C3)) of the content C1 of the first water-soluble polymer to the total content of the content C2 of the second water-soluble polymer and the content C3 of the third water-soluble polymer is 0.1 or more.

EP 4 498 403 A1

## Description

[Technical Field]

The present invention relates to a polishing composition. The application claims the priority based on Japanese Patent Application No. 2022-047438, filed on March 23, 2022, the content of which is herein incorporated by reference in its entirety.

[Background Art]

A surface of a material such as metal, semimetal, non-metal, or an oxide thereof has been finely polished with a polishing composition. For example, a surface of a silicon wafer used as a component of a semiconductor device or the like is generally finished into a high-grade mirror plane via a lapping step (rough polishing step) and a polishing step (fine polishing step). The polishing step typically includes a preliminary polishing step (stock polishing step) and a final polishing step (last polishing step). Patent Documents 1 to 5 are exemplary technical references of a polishing composition mainly used in application of polishing a semiconductor substrate such as a silicon wafer.

[Citation List]

[Patent Literature]

[Patent Document 1] Japanese Patent No. 5897200
[Patent Document 2] Japanese Patent No. 6037416
[Patent Document 3] Japanese Patent No. 6185432
[Patent Document 4] Japanese Patent No. 6232243
[Patent Document 5] Japanese Patent Application Publication No. 2020-13824

[Summary of Invention]

[Technical Problem]

A polishing composition for use has a polishing capability to efficiently polish an object to be polished. For example, polishing of a semiconductor substrate, such as a silicon wafer as described above, or other substrates can be leveraged by mechanical polishing action by an abrasive and chemical polishing action by a basic compound (alkali etching), which provide higher removal ability. A polishing composition with high removal ability is preferred because it enables improvement in production efficiency, cost effectiveness, etc. In such polishing, use of silica particles as an abrasive enables efficient preparation of a polishing surface with good quality.

In addition, a polishing composition used in polishing of the substrate, such as a polishing composition used in a final polishing step (particularly, a final polishing step of a semiconductor substrate such as a silicon wafer, or other substrates), is also required to have performance to provide a high-quality surface after polishing. Improvement in a surface quality of a polishing surface is provided by, e.g., a method of protecting a substrate by a water-soluble polymer contained in a polishing composition. For example, Patent Documents 1 to 5 disclose polishing compositions that contain silica particles, a basic compound, and a water-soluble polymer. Use of the water-soluble polymer can prevent excessive alkali etching on a surface of an object to be polished and avoid roughness on the polishing surface, but such prevented alkali etching may lead to reduced removal ability and thus less production efficiency. Patent Documents 1 to 5 disclose evaluation of surface qualities (haze and defects) with use of polishing compositions containing the water-soluble polymer but no investigation for removal ability. In general, there is a trade-off relationship between an improved quality of a polishing surface and a polishing removal rate, and it is practically beneficial to provide a polishing composition that can combine both of them at a high level, particularly in e.g., a final polishing step.

Under the circumstances, the inventors earnestly investigated and found that selection and use of specific three kinds of water-soluble polymers enable satisfying both of a surface quality and a polishing removal rate at a higher level relative to combination use of two kinds of water-soluble polymers, and finally completed the present invention. In other words, the present invention has an object to provide a polishing composition that can offer a high surface quality and enhance a polishing removal rate through selecting specific three kinds of water-soluble polymers.

[Solution to Problem]

The specification provides a polishing composition that contains silica particles as an abrasive, a basic compound, water, a cellulose derivative as a first water-soluble polymer, a polyvinyl alcohol-based polymer as a second water-soluble polymer, and a nitrogen atom-containing polymer as a third water-soluble polymer. In the polishing composition, the ratio (C1/(C2 + C3)) of the content C1 of the first water-soluble polymer to the total content of the content C2 of the second water-soluble polymer and the content C3 of the third water-soluble polymer is 0.1 or more on a weight basis. In a polishing composition containing silica particles, a basic compound, and water, the three kinds of water-soluble polymers as specified above can be selected and blended with balance, thereby providing a high surface quality and enhancing a polishing removal rate.

In some embodiments, the ratio (C3/C2) of the content C3 of the third water-soluble polymer to the content C2 of the second water-soluble polymer is 0.05 or more and less than 5 on a weight basis. Such composition can preferably offer an effect according to the art disclosed herein.

In some embodiments, the ratio (C3/(C1 + C2)) of the content C3 of the third water-soluble polymer to the total content of the content C1 of the first water-soluble polymer and the content C2 of the second water-soluble polymer is 0.18 or more and less than 10 on a weight basis. Such composition can preferably offer an effect according to the art disclosed herein.

In some embodiments, the silica particles have an average aspect ratio of 1.0 or more and 3.0 or less. Use of the silica particles with the average aspect ratio described above facilitates combination of a polishing removal rate and a surface quality.

In some embodiments, the third water-soluble polymer has a weight average molecular weight (Mw) of 50, 000 or more. Use of the third water-soluble polymer with a predetermined value or more of Mw tends to facilitate providing an effect to improve haze.

In some embodiments, the third water-soluble polymer is an acryloylmorpholine-based polymer. With containing an acryloylmorpholine-based polymer as the third water-soluble polymer, the polishing composition facilitates production of a high-quality polishing surface.

In some preferred embodiments, the content C1 of the first water-soluble polymer, the content C2 of the second water-soluble polymer, and the content C3 of the third water-soluble polymer meet the following relation on a weight basis: $C1 < (C2 + C3)$. Limited usage of a cellulose derivative as the first water-soluble polymer relative to the second and third water-soluble polymers facilitates achieving combination of improvement in a polishing removal rate and reduction in haze.

The polishing composition disclosed herein can be preferably used in polishing of a surface including a silicon material. Use of the polishing composition to polish a surface including a silicon material enables efficient preparation of a high-quality surface including a silicon material.

The polishing composition disclosed herein may be a concentrate. The polishing composition disclosed herein may be produced, distributed, and stored in a concentrate.

[Description of Embodiments]

Preferred embodiments of the present invention will be described below. Matters that are other than those particularly mentioned herein but are necessary for implementation of the present invention can be recognized as matters to be designed by those skilled in the art based on conventional technologies in the art. The present invention can be implemented based on contents disclosed herein and common technical knowledge in the art.

<Abrasive>

The polishing composition disclosed herein contains silica particles as an abrasive. Silica particles as an abrasive function to mechanically polish a surface of an object to be polished. Inclusion of an abrasive in the polishing composition allows enhancing a polishing removal rate based on mechanical polishing action from presence of an abrasive. When the polishing composition can be used in polishing (e.g., final polishing) of an object to be polished having a surface formed of silicon, such as a silicon wafer as described later, it is particularly significant to employ silica particles as an abrasive.

Specific examples of the silica particles include colloidal silica, fumed silica, and precipitated silica. The silica particles can be used singly or in combination of two or more kinds thereof. Colloidal silica is particularly preferably used because it facilitates production of a polishing surface with an excellent surface grade after polishing. Examples of colloidal silica to be potentially preferably employed include colloidal silica prepared from water glass (sodium silicate) as a raw material by ion-exchanging, and colloidal silica prepared from alkoxide (colloidal silica produced by a hydrolysis-condensation reaction of alkoxysilane). Colloidal silica can be used singly or in combination of two or more kinds thereof.

The absolute specific gravity of silica that forms the silica particles is preferably 1.5 or more, more preferably 1.6 or more, and even more preferably 1.7 or more. The upper limit of the absolute specific gravity of silica is not particularly limited, but is typically 2.3 or less, and e.g., 2.2 or less. As the absolute specific gravity of the silica particles, a measured value derived by liquid replacement using ethanol as a replacing liquid can be employed.

The average primary particle diameter of the abrasive (typically, silica particles) is not particularly limited, but in view of a polishing removal rate, etc., it is preferably 5 nm or more, and more preferably 10 nm or more. In view of providing a higher effect of polishing (an effect such as reduction in haze or removal of a defect), the average primary particle diameter is preferably 15 nm or more, and more preferably 20 nm or more (e.g., more than 20 nm). In view of preventing a scratch, etc., the average primary particle diameter of the abrasive is preferably 100 nm or less, more preferably 50 nm or less, and even more preferably 45 nm or less. In view of producing a lower-haze surface with ease, the average primary particle diameter of the abrasive in some embodiments may be 43 nm or less, less than 40 nm, less than 38 nm, less than 35 nm, less than 32 nm, or less than 30 nm.

An average primary particle diameter, as used herein, refers to a particle diameter (BET particle diameter) calculated from a specific surface area measured by a BET method (BET value) by the formula: average primary particle diameter (nm) = 6000/(true density (g/cm$^3$) $\times$ BET value (m$^2$/g)). The specific surface area can be measured using e.g., a surface area measurement device with the product name of "Flow Sorb II 2300", manufactured by Micromeritics Instrument Corporation.

The average secondary particle diameter of the abrasive (typically, silica particles) is not particularly limited, and can be appropriately selected from, e.g., the range of about 15 nm to 300 nm. In view of enhancing a polishing removal rate, the average secondary particle diameter is preferably 30 nm or more, and more preferably 35 nm or more. In some embodiments, the average secondary particle diameter may be, e.g., 40 nm or more, 42 nm or more, or preferably 44 nm or more. The average secondary particle diameter is usually, advantageously 250 nm or less, preferably 200 nm or less, and more preferably 150 nm or less. In some preferred embodiments, the average secondary particle diameter is 120 nm or less, more preferably 100 nm or less, and even more preferably 70 nm or less, and may be e.g., 60 nm or less or 50 nm or less.

An average secondary particle diameter, as used herein, refers to a particle diameter (volume average particle diameter) measured by dynamic light scattering. The average secondary particle diameter of the abrasive can be measured by dynamic light scattering using e.g., a product with the name of "NANOTRAC UPA-UT151", manufactured by Nikkiso Co., Ltd.

The shape (outer shape) of the silica particles may be globular or non-globular. Specific examples of the particles having non-globular forms include peanut-shaped (i.e., peanut shell-shaped) particles, cocoon-shaped particles, conpeito-shaped particles, and rugby ball-shaped particles. For example, silica particles majorly including peanut-shaped or cocoon-shaped particles may be preferably employed.

Without particular limitation, the average value of major axis/minor axis ratios (average aspect ratio) of the silica particles is theoretically 1.0 or more, preferably 1.05 or more, even more preferably 1.1 or more, and possibly 1.2 or more. Increase in the average aspect ratio can achieve a higher polishing removal rate. In view of reducing scratches, etc., the average aspect ratio of the silica particles is preferably 3.0 or less, more preferably 2.0 or less, even more preferably 1.5 or less, and possibly 1.4 or less.

An exemplary specific procedure for acquiring the shape (outer shape) and the average aspect ratio of the silica particles can be as follows: with use of a scanning electron microscope (SEM), collecting a predetermined number (e.g., 200) of the silica particles each independently having a discriminable shape; drawing a minimum rectangle circumscribed to an image of each of the collected particles; then calculating, as a major axis/minor axis ratio (aspect ratio), a value by dividing the long side length (major axis value) by the short side length (minor axis value) for the rectangle drawn for the image of each of the particles; and deriving the average aspect ratio from an arithmetic average of the aspect ratios for the predetermined number of the particles.

The polishing composition disclosed herein may contain an abrasive other than silica particles (hereinafter also referred to as "a non-silica abrasive"), as long as an effect of the present invention is not significantly inhibited. Examples of the non-silica abrasive include inorganic particles, organic particles, and organic-inorganic composite particles. Specific examples of the inorganic particles include oxide particles such as alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; and carbonate salts such as calcium carbonate and barium carbonate. Specific examples of the organic particles include polymethylmethacrylate (PMMA) particles, poly(meth)acrylic acid particles ((meth)acrylic acid in this context is intended to refer inclusively to acrylic acid and methacrylic acid), and polyacrylonitrile particles. Such abrasive can be used singly or in combination of two or more kinds thereof.

The art disclosed herein can be preferably performed in an embodiment where substantially only silica particles are used as an abrasive. In such a view, the proportion of silica particles in the total amount of the abrasive is suitably 90%

by weight or more, preferably 95% by weight or more, and more preferably 98% by weight or more (e.g., 99 to 100% by weight).

<Basic Compound>

The polishing composition disclosed herein contains a basic compound. As used herein, a basic compound refers to a compound having a function to be dissolved in water to rise the pH of an aqueous solution. Inclusion of a basic compound in the polishing composition provides chemical polishing action (alkali etching), by which an object to be polished can be efficiently polished. Available examples of the basic compound include organic or inorganic nitrogen-containing basic compounds, phosphorus-containing basic compounds, hydroxides of alkali metals, hydroxides of alkaline earth metals, and various carbonate salts or hydrogen carbonate salts. Examples of the nitrogen-containing basic compounds include quaternary ammonium compounds, ammonia, and amines (preferably, water-soluble amines). Examples of the phosphorus-containing basic compounds include quaternary phosphonium compounds. Such a basic compound can be used singly or in combination of two or more kinds thereof.

Specific examples of the hydroxides of alkali metals include potassium hydroxide and sodium hydroxide. Specific examples of the carbonate salts or hydrogen carbonate salts include ammonium hydrogen carbonate, ammonium carbonate, potassium hydrogen carbonate, potassium carbonate, sodium hydrogen carbonate, and sodium carbonate. Specific examples of the amines include, methylamine, dimethylamine, trimethylamine, ethylamine, diethylamine, triethylamine, ethylenediamine, monoethanolamine, N-(β-aminoethyl) ethanolamine, hexamethylenediamine, diethylenetriamine, triethylenetetramine, piperazine anhydride, piperazine hexahydrate, 1-(2-aminoethyl) piperazine, N-methylpiperazine, guanidine, and azoles such as imidazole and triazole. Specific examples of the quaternary phosphonium compounds include quaternary phosphonium hydroxides such as tetramethylphosphonium hydroxide and tetraethylphosphonium hydroxide.

As the quaternary ammonium compound, quaternary ammonium salts (typically, strong bases) such as tetraalkyl ammonium salts and hydroxyalkyl trialkyl ammonium salts can be used. An anion component in such quaternary ammonium salts may be, e.g., OH , $F^-$, $Cl^-$, $Br^-$, $I^-$, $ClO_4^-$, and $BH_4^-$. Examples of the quaternary ammonium compound include quaternary ammonium salts having $OH^-$ as an anion, i.e., quaternary ammonium hydroxides. Specific examples of the quaternary ammonium hydroxides include tetraalkyl ammonium hydroxides such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; hydroxyalkyl trialkylammonium hydroxides such as 2-hydroxyethyltrimethylammonium hydroxide (also referred to as choline).

Among these basic compounds, at least one kind of basic compound selected from hydroxides of alkali metal, quaternized ammonium hydroxide, and ammonia can be preferably used, for example. In particular, more preferred are tetraalkyl ammonium hydroxide (e.g., tetramethyl ammonium hydroxide) and ammonia, and particularly preferred is ammonia.

<Water-soluble Polymer>

The polishing composition disclosed herein is characterized by containing specific three kinds of water-soluble polymers as water-soluble polymers. In particular, the polishing composition contains a cellulose derivative as a first water-soluble polymer, a polyvinyl alcohol-based polymer as a second water-soluble polymer, and a nitrogen atom-containing polymer as a third water-soluble polymer. Selection and use of the specific three kinds of water-soluble polymers enables both offering a high surface quality and enhancing a polishing removal rate through use of the water-soluble polymers. Such enhancement in a polishing removal rate is achieved by selecting the three kinds of water-soluble polymers.

Description will now be made in detail for the first water-soluble polymer, the second water-soluble polymer, and the third water-soluble polymer.

<First Water-soluble Polymer>

The polishing composition disclosed herein contains a cellulose derivative as a first water-soluble polymer. The cellulose derivative is a polymer containing a β-glucose unit as a main repeating unit and has a structure derived from cellulose. Use of a cellulose derivative allows maintaining a polishing removal rate with a relatively high level and offering a high surface quality. Without being construed with any particular limitation, this may be because the cellulose derivative acts on both silica particles and a substrate (e.g., a silicon wafer) to moderately protect a substrate surface. Combination use of the cellulose derivative with the polyvinyl alcohol-based polymer described later also tends to cause both an action to protect a substrate based on a water-soluble polymer and enhancement in a polishing removal rate.

Specific examples of the cellulose derivative include hydroxyethyl cellulose (HEC), hydroxypropyl cellulose, hydroxyethylmethyl cellulose, hydroxypropylmethyl cellulose, methylcellulose, ethylcellulose, ethylhydroxyethyl cellulose, and carboxy methylcellulose. In particular, HEC is preferred. The cellulose derivative can be used singly or in combination of two or more kinds thereof.

The weight average molecular weight (Mw) of the cellulose derivative can be, approximately 200 $\times$ $10^4$ or less, and is suitably 150 $\times$ $10^4$ or less. The Mw may be approximately 100 $\times$ $10^4$ or less, approximately 50 $\times$ $10^4$ or less (e.g., less than approximately 50 $\times$ $10^4$), approximately 40 $\times$ $10^4$ or less, or approximately 30 $\times$ $10^4$ or less (e.g., less than 30 $\times$ $10^4$). When the cellulose derivative has an appropriately limited Mw, use of the cellulose derivative tends to result in a good surface quality with ease. In view of protection of a polishing surface, the Mw is, e.g., approximately 0.2 $\times$ $10^4$ or more, suitably approximately 0.5 $\times$ $10^4$ or more, preferably approximately 1.0 $\times$ $10^4$ or more, more preferably approximately 3.0 $\times$ $10^4$ or more, even more preferably approximately 10 $\times$ $10^4$ or more, possibly approximately 20 $\times$ $10^4$ or more.

As the Mw of the water-soluble polymer, a molecular weight calculated from a value based on aqueous gel permeation chromatography (GPC) (aqueous phase, on polyethylene oxide conversion basis) can be employed. The same applies to the MWs of the first water-soluble polymer described above and the second water-soluble polymer and the third water-soluble polymer described later. As a GPC measurement device, a machine with the name of "HLC-8320GPC", manufactured by Tosoh Corporation can be used. Measurement can be performed in accordance with, e.g., the following conditions. The same method is also employed to the examples described later.

[GPC Measurement Conditions]

Sample concentration: 0.1% by weight
Column: TSKgel $GMPW_{XL}$
Detector: differential refractometer
Elution liquid: 100 mM sodium nitrate aqueous solution/acetonitrile = 10 to 8/0 to 2
Flow rate: 1 mL/min
Measurement temperature: 40°C
Sample injection volume: 200 $\mu$L

Without particular limitation, the content of the first water-soluble polymer (particularly, a cellulose derivative) relative to 100 parts by weight of an abrasive (typically, silica particles) in the polishing composition in some embodiments can be e.g., 0.01 parts by weight or more, and is suitably 0.05 parts by weight or more. In some preferred embodiments, in view of better leveraging an use effect (e.g., haze reduction effect) of the first water-soluble polymer, the content is 0.1 parts by weight or more, more preferably 0.3 parts by weight or more, and even more preferably 0.5 parts by weight or more, and may be 1 part by weight or more, 2 parts by weight or more, or 3 parts by weight or more. The content of the first water-soluble polymer relative to 100 parts by weight of an abrasive in some embodiments may also be, e.g., 30 parts by weight or less, or 15 parts by weight or less. Limited usage of the first water-soluble polymer (particularly, a cellulose derivative) facilitates providing the polishing composition with good filterability and dispersion stability. In some preferred embodiments, in view of enhancing a polishing removal rate, the content of the first water-soluble polymer relative to 100 parts by weight of an abrasive is 10 parts by weight or less, more preferably 8 parts by weight or less, and even more preferably 6 parts by weight or less, and may be 5 parts by weight or less, or 4 parts by weight or less (e.g., 3 parts by weight or less). According to the art disclosed herein, appropriate control of the content of a cellulose derivative used as a water-soluble polymer enables both maintaining a high surface quality and enhancing a polishing removal rate.

<Second water-soluble Polymer>

The polishing composition disclosed herein contains a polyvinyl alcohol-based polymer as the second water-soluble polymer. With containing a polyvinyl alcohol-based polymer, the polishing composition tends to provide a polishing surface with high quality. Without being construed with any particular limitation, a polyvinyl alcohol-based polymer is considered to act on a substrate surface to protect a substrate surface, and to contribute to improvement in a polishing surface quality (particularly, reduction in haze) by an action different from that of the first water-soluble polymer. Use of a polyvinyl alcohol-based polymer as the second water-soluble polymer in combination with the first and third water-soluble polymers allows enhancement in a polishing removal rate and effectively achieves a high surface quality, based on different actions of each water-soluble polymer.

As used herein, a polyvinyl alcohol-based polymer refers to a polymer containing a vinyl alcohol unit (hereinafter also referred to as "VA unit") as a repeating unit therein. The polyvinyl alcohol-based polymer can be used singly or in combination of two or more kinds thereof. The polyvinyl alcohol-based polymer may contain only VA units as repeating units, or a repeating unit other than VA units in addition to VA units (hereinafter also referred to as "non-VA unit). The polyvinyl alcohol-based polymer may be a random copolymer, a block copolymer, an alternate copolymer, a graft

copolymer, or the like containing a VA unit and a non-VA unit. The polyvinyl alcohol-based polymer may contain only one kind of non-VA unit, or two or more kinds of non-VA units.

The polyvinyl alcohol-based polymer may be an unmodified polyvinyl alcohol (unmodified PVA) or a modified polyvinyl alcohol (modified PVA). An unmodified PVA, as used herein, refers to a polyvinyl alcohol-based polymer that is generated by hydrolyzing (saponifying) polyvinyl acetate and contains substantially no repeating unit other than repeating units having a structure derived by vinyl polymerization of vinyl acetate ($-CH_2-CH(OCOCH_3)-$) and VA units. The saponification degree of the unmodified PVA may be, e.g., 60% or more, and in view of water solubility, it may be 70% or more, 80% or more, or 90% or more. In some embodiments, the saponifying degree of the unmodified PVA may be 98% or more (fully saponified).

The polyvinyl alcohol-based polymer may be a modified PVA containing a VA unit, and a non-VA unit having at least one structure selected from an oxyalkylene group, a carboxy group, a (di)carboxylic group, a (di)carboxylic ester group, a phenyl group, a naphthyl group, a sulfo group, an amino group, a hydroxy group, an amide group, an imide group, a nitrile group, an ether group, an ester group, and salts thereof. Examples of a non-VA unit that may be contained in the modified PVA may include, but are not limited to, a repeating unit derived from an N-vinyl-type monomer, an N-(meth)acryloyl-type monomer, or the like as described later, a repeating unit derived from ethylene, a repeating unit derived from alkyl vinyl ether, a repeating unit derived from a vinyl ester of monocarboxylic acid having a carbon atom number of 3 or more, and a repeating unit derived from a (di)acetone compound. A preferred example of the N-vinyl-type monomer may be *N*-vinylpyrrolidone. A preferred example of the N-(meth)acryloyl-type monomer can be *N*-(meth)acryloyl morpholine. The alkyl vinyl ether may be vinyl ether having an alkyl group having a carbon atom number of 1 or more and 10 or less, such as propylvinyl ether, butyl vinyl ether, or 2-ethylhexylvinyl ether. The vinyl ester of monocarboxylic acid having a carbon atom number of 3 or more may be a vinyl ester of monocarboxylic acid having a carbon atom number of 3 or more and 7 or less, such as vinyl propionate, vinyl butylate, vinyl pentanoate, and vinyl hexanoate. Preferred examples of the (di)acetone compound include diacetone (meth)acrylamide and acetylacetone.

Moreover, in some preferred embodiments, an acetalized polyvinyl alcohol-based polymer is used as the polyvinyl alcohol-based polymer. Examples of the acetalized polyvinyl alcohol-based polymer include a modified PVA where a part of VA units in the polyvinyl alcohol-based polymer are acetalized. A modified PVA (acetalized PVA (ac-PVA)) derived by acetalizing a part of VA units in the polyvinyl alcohol-based polymer can be provided by reacting and acetalizing a part of hydroxy groups in the polyvinyl alcohol-based polymer with an aldehyde compound or a ketone compound. Typically, the acetalized polyvinyl alcohol-based polymer can be provided by an acetalized reaction of the polyvinyl alcohol-based polymer and an aldehyde compound. In some preferred embodiments, the carbon number of the aldehyde compound is 1 to 7, and more preferably 2 to 7.

Examples of the aldehyde compound include formaldehyde; linear or branched alkyl aldehydes such as acetaldehyde, propionaldehyde, n-butylaldehyde, isobutylaldehyde, t-butylaldehyde, pentylaldehyde, and hexylaldehyde; alicyclic or aromatic aldehydes such as cyclohexanecarbaldehyde and benzaldehyde. These can be used singly or in combination of two or more kinds thereof. The aldehyde compound may also have one or more hydrogen atoms substituted with halogen or the like except for formaldehyde. In particular, in view of high solubility to water and ease of an acetalization reaction, preferred are linear or branched alkyl aldehydes, and particularly more preferred are acetaldehyde, propylaldehyde, n-butylaldehyde, and n-pentylaldehyde.

As the aldehyde compound, in addition to the aforementioned substances, an aldehyde compound having a carbon number of 8 or more, such as 2-ethylhexylaldehyde, nonyl aldehyde, or decyl aldehyde, may be used.

The acetalized polyvinyl alcohol-based polymer contains a VA unit of a structural segment represented by the following chemical formula: $-CH_2-CH(OH)-$, and an acetalized structure unit represented by the following general formula (1) (hereinafter also referred to as "VAC unit").

[Chem 1]

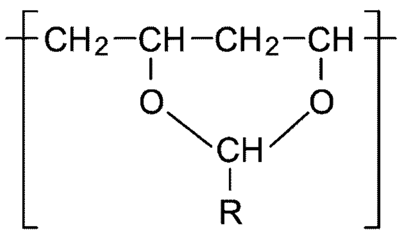

(1)

(in the formula (1), R is a hydrogen atom, or a linear or branched alkyl group, and the alkyl group may be substituted by a functional group.)

In some preferred embodiments, R in the formula (1) is a hydrogen atom or a linear or branched alkyl group

having a carbon number of 1 to 6. Among these, R may be one kind or a combination of two or more kinds. In view of enhancing performance to reduce haze, R is preferably a linear or branched alkyl chain having a carbon number of 1 to 6.

In view of enhancing performance to reduce haze, the acetalization degree of the acetalized polyvinyl alcohol-based polymer can be 1% by mole or more, may be 5% by mole or more, and is preferably 10% by mole or more, more preferably 15% by mole or more, even more preferably 20% by mole or more, and particularly preferably 25% by mole or more (e.g., 27% by mole or more). In view of enhancing hydrophilicity, the acetalization degree of the acetalized polyvinyl alcohol-based polymer is preferably less than 60% by mole, further 50% by mole or less, more preferably 40% by mole or less, and particularly preferably 35% by mole or less (e.g., 33% by mole or less). As used herein, the term "acetalization degree" refers to a proportion of acetalized structure units (VAC units) in all repeating units forming an acetalized polyvinyl alcohol-based polymer.

In addition, as a polyvinyl alcohol-based polymer, a cation-modified polyvinyl alcohol in which a cationic group such as a quaternary ammonium structure is introduced may be used. Examples of the cation-modified polyvinyl alcohol include a substance in which a cationic group derived from a monomer having a cationic group such as a diallyl dialkyl ammonium salt or an *N*-(meth)acryloyl aminoalkyl-*N*,*N*,*N*-trialkyl ammonium salt. The vinyl alcohol-based polymer may contain a non-VA unit having a structure segment represented by the chemical formula: $-CH_2-CH(CR^1(OR^4)-CR^2(OR^5)-R^3)-$. Note that $R^1$ to $R^3$ each indicate independently a hydrogen atom or an organic group, $R^4$ and $R^5$ each indicate independently a hydrogen atom or $R^6-CO-$ (wherein $R^6$ indicates an alkyl group). For example, when at least one of $R^1$ to $R^3$ in the chemical formula is an organic group, the organic group may be a liner or branched alkyl group having a carbon number of 1 or more and 8 or less, etc. $R^6$ in the chemical formula may be a linear or branched alkyl group having a number of 1 or more and 8 or less.

In some embodiments, as the modified PVA, a modified PVA having a 1,2-diol structure in a side chain is used. For example, as the modified PVA, a modified PVA with a non-VA unit containing hydrogen atoms as the $R^1$ to $R^5$ (butenediol-vinyl alcohol copolymer (BVOH)) may be preferably employed.

The proportion of the amount by mole of VA units in the amount by mole of all repeating units forming the polyvinyl alcohol-based polymer may be, e.g., 5% or more, 10% or more, 20% or more, or 30% or more. Without particular limitation, in some embodiments, the proportion of the amount by mole of the VA unit may be 50% or more, 65% or more, 75% or more, 80% or more, or 90% or more (e.g., 95% or more or 98% or more). Substantially 100% of repeating units forming the polyvinyl alcohol-based polymer may be VA units. As used herein, the phrase "substantially 100%" refers to not containing, at least intentionally, any non-VA unit in the polyvinyl alcohol-based polymer, and typically encompasses a case that the amount by mole of non-VA units is less than 2% (e.g., less than 1%) in the amount by mole of all repeating units, and a case of 0%. In some other embodiments, the proportion of the amount by mole of VA units in all repeating units forming the polyvinyl alcohol-based polymer may be, e.g., 95% or less, 90% or less, 80% or less, or 70% or less.

The content (content on a weight basis) of VA units in the polyvinyl alcohol-based polymer may be, e.g., 5% by weight or more, 10% by weight or more, 20% by weight or more, or 30% by weight or more. Without particular limitation, in some embodiments, the content of the VA units may be 50% by weight or more (e.g., more than 50% by weight), 70% by weight or more, or 80% by weight or more (e.g., 90% by weight or more, or 95% by weight or more, or 98% by weight or more). Substantially 100% by weight of repeating units forming the polyvinyl alcohol-based polymer may be VA units. As used herein, the phrase "substantially 100% by weight" refers to not containing, at least intentionally, any non-VA unit forming the polyvinyl alcohol-based polymer as a repeating unit, and typically means that the content of non-VA units is less than 2% by weight (e.g., less than 1% by weight) in the polyvinyl alcohol-based polymer. In some other embodiments, the content of VA units in the polyvinyl alcohol-based polymer may be, e.g., 95% by weight or less, 90% by weight or less, 80% by weight or less, or 70% by weight or less.

The polyvinyl alcohol-based polymer may contain a plurality of polymer chains having various contents of VA units within the same molecule. As used herein, a polymer chain refers to a portion (segment) forming a part of a single molecule polymer. For example, the polyvinyl alcohol-based polymer may contain Polymer chain A, where the content of VA units is more than 50% by weight, and Polymer chain B, where the content of VA units is less than 50% by weight (i.e., the content of non-VA units is more than 50% by weight), within the same molecule.

Polymer chain A may contain only VA units as repeating units, or a non-VA unit in addition to VA units. The content of VA units in Polymer chain A may be 60% by weight or more, 70% by weight or more, 80% by weight or more, or 90% by weight or more. In some embodiments, the content of VA units in Polymer chain A may be 95% by weight or more, or 98% by weight or more. Substantially 100% by weight of repeating units forming Polymer chain A may be VA units.

Polymer chain B may contain only non-VA units as a repeating unit, or a VA unit in addition to non-VA units. The content of non-VA units in Polymer chain B may be 60% by weight or more, 70% by weight or more, 80% by weight or more, or 90% by weight or more. In some embodiments, the content of non-VA units in Polymer chain B may be 95% by weight or more, or 98% by weight or more. Substantially 100% by weight of repeating units forming Polymer chain B may be non-VA units.

Examples of a polyvinyl alcohol-based polymer containing Polymer chain A and Polymer chain B within the same molecule include a block copolymer, a graft copolymer, and the like containing these polymer chains. The graft copolymer

may be a graft copolymer having a structure of Polymer chain A (main chain) grafted with Polymer chain B (side chain), or a graft copolymer having a structure of Polymer chain B (main chain) grafted with Polymer chain A (side chain). In some embodiments, a polyvinyl alcohol-based polymer having a structure of Polymer chain A grafted with Polymer chain B can be used.

Examples of Polymer chain B include a polymer chain containing a repeating unit derived from an N-vinyl-type monomer as a main repeating unit; a polymer chain containing a repeating unit derived from an N-(meth)acryloyl-type monomer as a main repeating unit; a polymer chain containing a repeating unit derived from dicarboxylic vinyl such as fumaric acid, maleic acid, or maleic anhydride, as a main repeating unit; a polymer chain containing a repeating unit derived from an aromatic vinyl monomer such as styrene and vinylnaphthalene as a main repeating unit; and a polymer chain containing an oxyalkylene unit as a main repeating unit. Note that a main repeating unit herein refers to a repeating unit occupying more than 50% by weight unless otherwise stated.

A preferred example of Polymer chain B is a polymer chain containing an *N*-vinyl-type monomer as a main repeating unit, i.e., an *N*-vinyl-based polymer chain. The content of repeating units derived from *N*-vinyl-type monomers in an *N*-vinyl-based polymer chain is typically more than 50% by weight, and may be 70% by weight or more, 85% by weight or more, or 95% by weight or more. Substantially the whole of Polymer chain B may be formed of repeating units derived from N-vinyl-type monomers.

Herein, examples of the *N*-vinyl-type monomer include a monomer having a nitrogen-containing heterocycle (e.g., lactam ring), and *N*-vinyl linear amide. Specific examples of the *N*-vinyl lactam-type monomer include *N*-vinylpyrrolidone, *N*-vinylpiperidone, *N*-vinylmorpholinone, *N*-vinylcaprolactam, *N*-vinyl-1,3-oxazine-2-one, and *N*-vinyl-3,5-morpholinedione. Specific examples of the *N*-vinyl linear amide include *N*-vinyl acetoamide, N-vinyl propionamide, and *N*-vinyl butyramide. Polymer chain B may be, e.g., an *N*-vinyl-based polymer chain containing *N*-vinylpyrrolidone units occupying more than 50% by weight (e.g., 70% by weight or more, or 85% by weight or more, or 95% by weight or more) of repeating units. Substantially all of repeating units forming Polymer chain B may be *N*-vinylpyrrolidone units.

Other examples of Polymer chain B include a polymer chain containing a repeating unit derived from an *N*-(meth)acryloyl-type monomer as a main repeating unit, i.e., an *N*-(meth)acryloyl-based polymer chain. The content of repeating units derived from *N*-(meth)acryloyl-type monomers in an *N*-(meth)acryloyl-based polymer chain is typically more than 50% by weight, and may be 70% by weight or more, 85% by weight or more, or 95% by weight or more. Substantially the whole of Polymer chain B may be formed of repeating units derived from *N*-(meth)acryloyl-type monomers.

Herein, examples of the *N*-(meth)acryloyl-type monomer include a linear amide having an *N*-(meth)acryloyl group, and a cyclic amide having an *N*-(meth)acryloyl group. Examples of the linear amide having an *N*-(meth)acryloyl group include (meth)acrylamide; *N*-alkyl (meth)acrylamides such as *N*-methyl (meth)acrylamide, *N*-ethyl (meth)acrylamide, *N*-propyl (meth)acrylamide, *N*-isopropyl (meth)acrylamide, and *N*-*n*-butyl (meth)acrylamide; and *N*,*N*-dialkyl (meth) acrylamide such as *N*,*N*-dimethyl (meth)acrylamide, *N*,*N*-diethyl (meth)acrylamide, *N,N*-dipropyl (meth)acrylamide, *N*,*N*-diisopropyl (meth)acrylamide, and *N*,*N*-di(n-butyl) (meth)acrylamide. Examples of the cyclic amide having an *N*-(meth) acryloyl group include *N*-(meth)acryloyl morpholine and *N*-(meth)acryloyl pyrrolidine.

Other examples of Polymer chain B include a polymer chain containing an oxyalkylene unit as a main repeating unit, i.e., an oxyalkylene-based polymer chain. The content of oxyalkylene units in the oxyalkylene-based polymer chain is typically more than 50% by weight, and may be 70% by weight or more, 85% by weight or more, or 95% by weight or more. Substantially all of repeating units in Polymer chain B may be oxyalkylene units.

Examples of the oxyalkylene unit include an oxyethylene unit, an oxypropylene unit, and an oxybutylene unit. Each of these oxyalkylene units may be a repeating unit derived from a corresponding alkylene oxide. Oxyalkylene units in the oxyalkylene-based polymer chain may consist of one kind or two or more kinds. For example, the oxyalkylene-based polymer chain may contain oxyethylene units and oxypropylene units in combination. In an oxyalkylene-based polymer chain containing two or more kinds of oxyalkylene units, each of these oxyalkylene units may be a random copolymer, a block copolymer, an alternate copolymer, a graft copolymer, or the like of a corresponding alkylene oxide.

Further examples of Polymer chain B include a polymer chain containing a repeating unit derived from alkyl vinyl ether (e.g., vinyl ether with an alkyl group having a carbon atom number of 1 or more and 10 or less), a polymer chain containing a repeating unit derived from monocarboxylic vinyl ester (e.g., vinyl ester of monocarboxylic acid having a carbon atom number of 3 or more), and a polymer chain introducing a cationic group (e.g., a cationic group having a quaternary ammonium structure).

A polyvinyl alcohol-based polymer as the second water-soluble polymer in the art disclosed herein is preferably a modified polyvinyl alcohol that is a copolymer containing a VA unit and a non-VA unit. The saponification degree of the polyvinyl alcohol-based polymer as the second water-soluble polymer is usually 50% by mole or more, preferably 65% by mole or more, more preferably 70% by mole or more, and e.g., 75% by mole or more. When a modified PVA having a 1,2-diol structure is used as a copolymer containing a VA unit and a non-VE1 unit, the saponification degree of the polyvinyl alcohol-based polymer may be 95% by mole or more (e.g., more than 95% by mole), or 98% by mole or more. Note that the saponification degree of the polyvinyl alcohol-based polymer is theoretically 100% by mole or less.

Without particular limitation, in some embodiments, when the non-VA unit contains a nitrogen atom, a polymer

having a content of VA units of 50% by weight or more is used as the second water-soluble polymer (polyvinyl alcohol-based polymer).

The weight average molecular weight (Mw) of the polyvinyl alcohol-based polymer can be $100 \times 10^4$ or less, and is suitably $60 \times 10^4$ or less. In view of concentration efficiency and the like, the Mw may be $30 \times 10^4$ or less, preferably $20 \times 10^4$ or less, e.g., $10 \times 10^4$ or less, $8 \times 10^4$ or less, $5 \times 10^4$ or less, or $3 \times 10^4$ or less. When the polyvinyl alcohol-based polymer has a smaller Mw, the polyvinyl alcohol-based polymer tends to have improved dispersion stability. Additionally, in view of preferably protecting a polishing surface and maintaining or improving a surface quality, the Mw may be e.g., $0.2 \times 10^4$ or more, and is usually preferably $0.5 \times 10^4$ or more. Increase in the Mw of the polyvinyl alcohol-based polymer leads to a tendency to provide higher effects to protect an object to be polished and increase wettability. In such a view, the Mw in some embodiments is suitably $0.8 \times 10^4$ or more, and preferably $1.0 \times 10^4$ or more, and may be $2 \times 10^4$ or more, $3 \times 10^4$ or more, e.g., $4 \times 10^4$ or more, or $5 \times 10^4$ or more.

Without particular limitation, the content of the second water-soluble polymer (particularly, a polyvinyl alcohol-based polymer) relative to 100 parts by weight of an abrasive (typically, silica particles) in some embodiments can be e.g., 0.01 parts by weight or more, and in view of reducing haze, the content is suitably 0.1 parts by weight or more, preferably 0.5 parts by weight or more, and more preferably 1 part by weight or more, and may be 1.5 parts by weight or more, or 2 parts by weight or more. The content of the second water-soluble polymer relative to 100 parts by weight of an abrasive may also be, e.g., 50 parts by weight or less, or 30 parts by weight or less. In view of dispersion stability of the polishing composition, etc., the content of the second water-soluble polymer relative to 100 parts by weight of an abrasive in some embodiments is suitably 15 parts by weight or less, preferably 10 parts by weight or less, and more preferably 5 parts by weight or less, and may be 3 parts by weight or less or 2 parts by weight or less. Appropriate setting of usage of the second water-soluble polymer (particularly, a polyvinyl alcohol-based polymer) from the aforementioned range provides better combination of a high surface quality and an enhanced polishing removal rate. Without being construed with any particular limitation, control of usage of the second water-soluble polymer (particularly, a polyvinyl alcohol-based polymer) may cause moderate limitation of action to protect a substrate surface (e.g., to reduce alkali etching) by the first and third water-soluble polymers, thereby both maintaining a high surface quality and enhancing a polishing removal rate.

<Third Water-soluble Polymer>

The polishing composition disclosed herein contains a polymer containing a nitrogen atom (nitrogen atom-containing polymer) as a third water-soluble polymer. The polymer containing a nitrogen atom may be typically a polymer that contains a repeating unit derived from a monomer having a nitrogen atom (a repeating unit containing a nitrogen atom). With containing a nitrogen atom-containing polymer, the polishing composition is likely to provide a high-quality polishing surface. Without being construed with any particular limitation, the nitrogen atom-containing polymer is considered to protect a substrate surface based on absorption to silica particles, and contribute to an improved quality (particularly, reduction in haze) of a polishing surface through action different from actions of the first and second water-soluble polymers. Combination use of a nitrogen atom-containing polymer as the third water-soluble polymer with the first and second water-soluble polymers enables both enhancing a polishing removal rate and achieving a high surface quality, based on a different action from each water-soluble polymer.

Any of polymers containing a nitrogen atom in a main chain or polymers containing a nitrogen atom in a side chain (a pendant group) can be used as the nitrogen atom-containing polymer. Examples of the polymers containing a nitrogen atom in a main chain include alkylene polyalkylene oxide amine polymers. Examples of the polymers containing a nitrogen atom in a side chain include N-vinyl-type polymers and N-(meth)acryloyl-type polymers. Other examples of the nitrogen atom-containing polymer include polymers having an alkylenediamine structure such as ethylenediamine tetrapolyoxyethylene polyoxypropylene (poloxamine). The nitrogen atom-containing polymer can be used singly or in combination of two or more kinds thereof.

In some embodiments, an alkylene polyalkylene oxide amine polymer can be used as the nitrogen atom-containing polymer. An alkylene polyalkylene oxide amine polymer encompasses a polymer containing a repeating unit having a tertiary amine where an alkylene group and a polyalkylene oxide group are bound to a nitrogen atom.

An alkylene polyalkylene oxide amine polymer can be produced by any method known to persons having ordinary skill in the art. For example, an alkylene polyalkylene oxide amine polymer can be produced by addition polymerization of alkyleneoxide to an active hydrogen on a polyamine compound having two or more primary amino groups and/or secondary amino groups and containing 4 to 100 nitrogen atoms in a molecule. Examples of the polyamine compound to provide a main chain structure include polyethylene polyamine such as triethylene tetramine, tetraethylene pentamine, pentaethylene hexamine, and hexaethylene heptamine; and polyalkyleneimine such as polyethyleneimine produced by polymerization of ethyleneimine. These compounds can be used singly or in combination of two or more kinds thereof to form a main chain structure. Examples of alkyleneoxide to be added to the main chain structure include ethylene oxide, propylene oxide, and butylene oxide. These alkyleneoxides can be used singly or in combination of two or more kinds thereof. In some embodiments, an *N*-vinyl-type polymer may be used as the nitrogen atom-containing polymer.

Examples of the *N*-vinyl-type polymer include a polymer containing a repeating unit derived from a monomer having a nitrogen-containing heterocycle (e.g., lactam ring). Examples of such a polymer include homopolymers and copolymers of *N*-vinyllactam-type monomers (e.g., a copolymer containing *N*-vinyllactam-type monomers with a copolymerization ratio of more than 50% by weight), and homopolymers and copolymers of *N*-vinyl linear amide (e.g., a copolymer containing *N*-vinyl linear amide with a copolymerization ratio of more than 50% by weight).

Specific examples of the *N*-vinyllactam-type monomer (i.e., a compound having a lactam structure and an *N*-vinyl group within one molecule) include *N*-vinylpyrrolidone (VP), *N*-vinylpiperidone, *N*-vinylmorpholinone, *N*-vinylcaprolactam (VC), *N*-vinyl-1,3-oxazine-2-one, and *N*-vinyl-3,5-morpholinedione. Specific examples of a polymer containing the *N*-vinyllactam-type monomer unit include polyvinyl pyrrolidone; polyvinyl caprolactam; a random copolymer of VP and VC; a random copolymer of one or both of VP and VC with another vinyl monomer (e.g., an acrylic monomer and a vinyl ester-based monomer) ; and a block copolymer, an alternate copolymer, a graft copolymer, and the like containing a polymer chain containing one or both of VP and VC.

Specific examples of the *N*-vinyl linear amide include *N*-vinylacetoamide, *N*-vinyl-propionamide, and *N*-vinyl butyramide.

In some embodiments, *N*-(meth)acryloyl-type polymer can be used as the third water-soluble polymer. An effect by the art disclosed herein can be more preferably achieved in composition containing an *N*-(meth)acryloyl-type polymer. Examples of the *N*-(meth)acryloyl-type polymer include homopolymers and copolymers of *N*-(meth)acryloyl-type monomers (typically, a copolymer containing *N*-(meth)acryloyl-type monomers with a copolymerization ratio of more than 50% by weight). Examples of the *N*-(meth)acryloyl-type monomers include linear amides containing an *N*-(meth)acryloyl group and cyclic amides containing an *N*-(meth)acryloyl group.

Examples of the linear amide having an *N*-(meth)acryloyl group include (meth)acrylamides; *N*-alkyl (meth) acrylamides such as *N*-methyl (meth)acrylamide, *N*-ethyl (meth)acrylamide, *N*-propyl (meth)acrylamide, *N*-isopropyl (meth)acrylamide, and *N*-n-butyl (meth)acrylamide; *N*,*N*-dialkyl (meth)acrylamides such as *N*,*N*-dimethyl (meth)acrylamide, *N,N*-diethyl (meth)acrylamide, *N*,*N*-dipropyl (meth)acrylamide, *N*,*N*-diisopropyl (meth)acrylamide, and *N*,*N*-di(*n*-butyl) (meth)acrylamide. Examples of a polymer containing the linear amide having an *N*-(meth)acryloyl group as a monomer unit include a homopolymer of *N*-isopropylacrylamide and a copolymer of *N*-isopropylacrylamide (e.g., a copolymer containing *N*-isopropylacrylamide with a copolymerization ratio of more than 50% by weight).

Examples of the cyclic amide having an *N*-(meth)acryloyl group include *N*acryloylmorpholine, *N*-acryloylthiomorpholine, *N*-acryloylpiperidine, *N*-acryloylpyrrolidine, *N*-methacryloylmorpholine, *N*-methacryloylpiperidine, and *N*-methacryloylpyrrolidine. Examples of a polymer containing the cyclic amide having an *N*-(meth)acryloyl group as a monomer unit include an acryloyl morpholine-based polymer (PACMO). Typical examples of the acryloyl morpholine-based polymer include a homopolymer of Nacryloylmorpholine (ACMO) and a copolymer of ACMO (e.g., a copolymer containing ACMO with a copolymerization ratio of more than 50% by weight). In the acryloyl morpholine-based polymer, the proportion of the amount by mole of ACMO units in the amount by mole of all repeating units is usually 50% or more, and suitably 80% or more (e.g., 90% or more, typically 95% or more). All repeating units in the water-soluble polymer may be substantially occupied by ACMO units.

Without particular limitation, in some embodiments, a polymer having a content of VA units of less than 50% by weight is used as the third water-soluble polymer (a nitrogen atom-containing polymer).

The weight average molecular weight (Mw) of the nitrogen atom-containing polymer (e.g., N-(meth)acryloyl-type polymer, preferably PACMO) can be, e.g., $100 \times 10^4$ or less, and is suitably $70 \times 10^4$ or less. In view of concentration efficiency, etc., the Mw may be $60 \times 10^4$ or less, or $50 \times 10^4$ or less. In view of maintaining and improving a surface quality, the Mw may also be, e.g., $1.0 \times 10^4$ or more, $5 \times 10^4$ or more, or $10 \times 10^4$ or more (e.g., more than $10 \times 10^4$). In some embodiments, the Mw is suitably $20 \times 10^4$ or more, preferably $30 \times 10^4$ or more, more preferably $35 \times 10^4$ or more, and particularly preferably $40 \times 10^4$ or more (e.g., more than $40 \times 10^4$). When the nitrogen atom-containing polymer has a high Mw, use of the nitrogen atom-containing polymer is likely to offer a high surface quality. Without particular limitation, in some embodiments, a polymer having a Mw higher than the Mw of the second water-soluble polymer can be preferably used as the third water-soluble polymer (particularly, nitrogen atom-containing polymer). Employment of the Mws of two kinds of water-soluble polymers having the relative Mw as described above enables preferably achieving combination of a polishing removal rate and a surface quality.

Without particular limitation, in some embodiments, the content of the third water-soluble polymer (particularly, a nitrogen atom-containing polymer) relative to 100 parts by weight of an abrasive (typically, silica particles) in the polishing composition can be, e.g., 0.01 parts by weight or more, and in view of reduction in haze, etc., it is suitably 0.1 parts by weight or more, preferably 0.5 parts by weight or more, more preferably 1 part by weight or more, and possibly 2 parts by weight or more. The content of the nitrogen atom-containing polymer relative to 100 parts by weight of an abrasive may be, e.g., 50 parts by weight or less, or 30 parts by weight or less. In view of dispersion stability of the polishing composition, etc., the content of the nitrogen atom-containing polymer relative to 100 parts by weight of an abrasive in some embodiments is suitably 15 parts by weight or less, preferably 10 parts by weight or less, more preferably 5 parts by weight or less, and possibly, e.g., 3.5 parts by weight or less. Appropriate setting of usage of the third water-soluble polymer (particularly, a

nitrogen atom-containing polymer) from the aforementioned range enables providing a high surface quality.

Without particular limitation, in some embodiments, the total content of three kinds of water-soluble polymers (the first, second, and third water-soluble polymers) relative to 100 parts by weight of an abrasive (typically, silica particles) in the polishing composition can be, e.g., 0.01 parts by weight or more, and in view of reduction in haze, etc., it is suitably 0.1 parts by weight or more, preferably 0.5 parts by weight or more, more preferably 1 part by weight or more, even more preferably 2 parts by weight or more, particularly preferably 4 parts by weight or more, and possibly 6 parts by weight or more. The total content of the water-soluble polymer relative to 100 parts by weight of an abrasive may be, e.g., 50 parts by weight or less, or 30 parts by weight or less. In view of dispersion stability of the polishing composition, in some embodiments, the total content of the water-soluble polymer relative to 100 parts by weight of an abrasive is suitably 15 parts by weight or less, preferably 12 parts by weight or less, and possibly 10 parts by weight or less (e.g., less than 10 parts by weight).

In the polishing composition disclosed herein, the ratio (C1/(C2 + C3)) of the content C1 of the first water-soluble polymer to the total content of the content C2 of the second water-soluble polymer and the content C3 of the third water-soluble polymer is 0.1 or more on a weight basis. An effect from the art disclosed herein can be achieved in composition containing the first, second and third water-soluble polymers at the ratio described above. In some embodiments, the ratio (C1/(C2 + C3)) may be, e.g., 0.2 or more, 0.4 or more, 0.5 or more, or 0.6 or more on a weight basis. Increase in the ratio (C1/(C2 + C3)) can lead to effective exertion of action of a cellulose derivative as the first water-soluble polymer. The upper limit value of the ratio (C1/(C2 + C3)) is not particularly limited, and is, e.g., 10 or less and possibly 5 or less on a weight basis. In view of preferably exerting an effect from the art disclosed herein (in particular, enhancement in a polishing removal rate), in some embodiments, the ratio (C1/(C2 + C3)) is, e.g., 4.5 or less, preferably 4 or less, more preferably 3 or less, and even more preferably 2 or less on a weight basis. In some preferred embodiments, composition may be employed where the content C1 of the first water-soluble polymer is less than the total content of the content C2 of the second water-soluble polymer and the content C3 of the third water-soluble polymer. In other words, the composition satisfying the following formula may be employed : $C1 < (C2 + C3)$. Such composition in which the ratio (C1/(C2 + C3)) is less than 1 (on a weight basis) enables combining a high surface quality (e.g., reduction in a haze value) and enhancement in a polishing removal rate at a higher level. The ratio (C1/(C2 + C3)) may be less than 0.9, less than 0.7, or less than 0.5 on a weight basis.

Without particular limitation, in some embodiments, the ratio (C3/(C1 + C2)) of the content C3 of the third water-soluble polymer to the total content of the content C1 of the first water-soluble polymer and the content C2 of the second water-soluble polymer is, e.g., 0.1 or more, and suitably 0.15 or more on a weight basis. In some preferred embodiments, the ratio (C3/(C1 + C2)) is 0.18 or more, and may be 0.30 or more, 0.40 or more, 0.50 or more, or 0.60 or more. Setting of the ratio (C3/(C1 + C2)) to such predetermined values or more facilitates providing a high surface quality. The upper limit value of the ratio (C3/(C1 + C2)) is e.g., 10 or less (e.g., less than 10), and suitably 5 or less on a weight basis. In some preferred embodiments, the ratio (C3/(C1 + C2)) is, e.g., 1 or less (e.g., less than 1), and may be 0.8 or less, 0.7 or less, or 0.6 or less on a weight basis. Limitation of the ratio (C3/(C1 + C2)) to such predetermined values or less tends to facilitate providing an effect to enhance a polishing removal rate.

Without particular limitation, in some embodiments, the ratio C2/(C1 + C3) of the content C2 of the second water-soluble polymer to the total content of the content C1 of the first water-soluble polymer and the content C3 of the third water-soluble polymer is, e.g., 0.1 or more, and suitably 0.2 or more, and may be 0.3 or more, 0.5 or more, 0.7 or more, or 1 or more on a weight basis. Setting of the ratio C2/(C1 + C3) to such predetermined values or more can lead to effective exertion of action of a polyvinyl alcohol-based polymer as a second water-soluble polymer. The upper limit value of the ratio C2/(C1 + C3) is, e.g., 10 or less, and may be 5 or less, 3 or less, or 1 or less on a weight basis. Appropriate setting of the ratio C2/(C1 + C3) within the aforementioned range can lead to preferable exertion of an effect of the art disclosed herein.

Without particular limitation, in some embodiments, the ratio (C3/C2) of the content C3 of the third water-soluble polymer to the content C2 of the second water-soluble polymer is e.g., 0.01 or more on a weight basis. In some preferred embodiments, the ratio (C3/C2) is 0.05 or more, more preferably 0.1 or more, and even more preferably 0.3 or more, and may be 0.5 or more, or 0.7 or more on a weight basis. Setting of the ratio (C3/C2) to such predetermined values or more facilitates providing a high surface quality. The upper limit value of the ratio (C3/C2) is, e.g., 10 or less, and suitably 5 or less (e.g., less than 5) on a weight basis. In some preferred embodiments, the ratio (C3/C2) is 3 or less, more preferably 2 or less, and possibly 1 or less. Setting the ratio (C3/C2) lower within such predetermined ranges facilitates both maintaining a high surface quality and providing a higher polishing removal rate.

Without particular limitation, in some embodiments, the ratio (C1/C3) of the content C1 of the first water-soluble polymer to the content C3 of the third water-soluble polymer is, e.g., 0.1 or more, and suitably 0.3 or more on a weight basis. In some preferred embodiments, the ratio (C1/C3) is 0.5 or more, and may be 0.8 or more, or 1 or more. The upper limit value of the ratio (C1/C3) is, e.g., 10 or less, and in some preferred embodiments, it is 5 or less, and may be 3 or less, and 1.5 or less on a weight basis. Appropriate setting of the ratio (C1/C3) within such ranges can lead to preferable exertion of an effect of the art disclosed herein.

Without particular limitation, in some embodiments, the ratio (C1/C2) of the content C1 of the firstwater-soluble

polymer to the content C2 of the second water-soluble polymer is, e.g., 0.01 or more, suitably 0.1 or more, and preferably 0.2 or more, and may be 0.4 or more, 0.6 or more, or 0.8 or more on a weight basis. The upper limit value of the ratio (C1/C2) is, e.g., 10 or less, suitably 5 or less, preferably 3 or less, and possibly 1 or less (less than 1) on a weight basis. Appropriate setting of the ratio (C1/C2) within such ranges can lead to preferable exertion of an effect of the art disclosed herein.

Without particular limitation, the contents and ratio (e.g., ratio (C1/(C2 + C3)) of the first, second, and third water-soluble polymers can be preferably employed in, e.g., a silicon wafer polishing composition, and is particularly preferable for final polishing composition of a silicon wafer.

<Optional Water-soluble Polymer>

The polishing composition disclosed herein may contain, as an optional component, a water-soluble polymer (hereinafter also referred to as an optional water-soluble polymer) other than the first water-soluble polymer, the second water-soluble polymer, and the third water-soluble polymer, as long as an effect of the present invention is not to be significantly prevented. As such an optional water-soluble polymer, a polymer containing a starch derivative or an oxyalkylene unit may be used, for example.

Examples of the starch derivative include pregelatinized starch, pullulan, carboxymethyl starch, and cyclodextrin.

Examples of the oxyalkylene unit-containing polymer include polyethylene oxide (PEO), a block copolymer of ethylene oxide (EO) and propylene oxide (PO) or butylene oxide (BO), and a random copolymer of EO and PO or BO. In particular, preferred are a block copolymer of EO and PO and a random copolymer of EO and PO. The block copolymer of EO and PO may be a diblock copolymer or a triblock copolymer containing a PEO block and a polypropylene oxide (PPO) block, or the like. Examples of the triblock copolymer include PEO-PPO-PEO type triblock copolymers and PPO-PEO-PPO type triblock copolymers. Usually, more preferred are PEO-PPO-PEO type triblock copolymers.

A copolymer, as used herein, is intended to inclusively refer to various copolymers such as random copolymers, alternate copolymers, block copolymers, and graft copolymers, unless otherwise stated.

In a block copolymer or a random copolymer of EO and PO, the molar ratio (EO/PO) of EO and PO forming the copolymer is preferably more than 1, more preferably 2 or more, and even more preferably 3 or more (e.g., 5 or more) in view of solubility in water, cleanability, etc.

In an embodiment where the polishing composition contains an optional water-soluble polymer, the content ratio of the optional water-soluble polymer to the total water-soluble polymers in the polishing composition is not particularly limited, but in view of effectively exerting actions of the first, second, and third water-soluble polymers, it is suitably approximately 50% by weight or less (e.g., less than 50% by weight), and may be 30% by weight or less, less than 10% by weight, less than 3% by weight, or less than 1% by weight. The art disclosed herein may be preferably performed in an embodiment where the polishing composition contains substantially no optional water-soluble polymer.

< Surfactant>

In some embodiments, the polishing composition preferably contains at least one kind of surfactant. Inclusion of a surfactant in the polishing composition can further reduce haze on a polished surface. According to the art disclosed herein, composition containing the combination of water-soluble polymers described above and a surfactant enables both maintaining a quality (particularly, haze) of a polishing surface and enhancing a polishing removal rate. As the surfactant, any of anionic, cationic, nonionic, or amphoteric substance is available. Usually, an anionic or nonionic surfactant can be preferably employed. In view of low foamability, ease of pH adjustment, etc., a nonionic surfactant is more preferable. Examples thereof include nonionic surfactants including oxyalkylene polymers such as polyethylene glycol, polypropylene glycol, and polytetramethylene glycol; polyoxyalkylene derivatives (e.g., polyoxyalkylene adducts) such as polyoxyethylene alkyl ether, polyoxyethylene alkyl phenylether, polyoxyethylene alkyl amine, polyoxyethylene fatty acid ester, polyoxyethylene glycerylether fatty acid ester, and polyoxyethylene sorbitan fatty acid ester; and copolymers of plural kinds of oxyalkylene (e.g., diblock type copolymers, triblock type copolymers, random type copolymers, and alternate copolymers). The surfactant can be used singly or in combination of two or more kinds thereof.

Specific examples of the nonionic surfactant include block copolymers of ethylene oxide (EO) and propylene oxide (PO) (diblock type copolymers, PEO (polyethylene oxide)-PPO (polypropylene oxide)-PEO type triblock units, PPO-PEO-PPO type triblock copolymers, etc.), random copolymers of EO and PO, polyoxyethylene glycol, polyoxyethylene propylether, polyoxyethylene butylether, polyoxyethylene pentylether, polyoxyethylene hexylether, polyoxyethylene octylether, polyoxyethylene-2-ethylhexylether, polyoxyethylene nonylether, polyoxyethylene decylether, polyoxyethylene isodecylether, polyoxyethylene tridecylether, polyoxyethylene laurylether, polyoxyethylene cetylether, polyoxyethylene stearylether, polyoxyethylene isostearylether, polyoxyethylene oleylether, polyoxyethylene phenylether, polyoxyethylene octylphenylether, polyoxyethylene nonylphenylether, polyoxyethylene dodecylphenylether, polyoxyethylene styrated phenylether, polyoxyethylene laurylamine, polyoxyethylene stearylamine, polyoxyethylene oleylamine, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, and polyoxyethylene castor wax. Particularly preferred examples of the surfactant include block copolymers of EO and PO (in particular, PEO-PPO-PEO type triblock copolymers), random copolymers of EO and PO, and polyoxyethylene alkyl ether (e.g., polyoxyethylene decylether). As such polyoxyethylene alkyl ether, a substance in which the number of EO moles added is about 1 to 10 (e.g., about 3 to 8) can be preferably employed.

In some embodiments, a nonionic surfactant is preferably used. Use of a nonionic surfactant tends to further enhance performance to reduce haze.

The molecular weight of the surfactant is, e.g., less than $1 \times 10^4$, and in view of filterability, cleanability, etc., it is preferably 9500 or less, and may be, e.g., less than 9000. In view of interfacial action or the like, the molecular weight of the surfactant is also usually, suitably 200 or more, and in view of an effect to reduce haze or the like, it is preferably 250 or more (e.g., 300 or more). The more preferred range of the molecular weight of the surfactant may also be varied corresponding to the type of the surfactant. For example, when polyoxyethylene alkyl ether is used as a surfactant, the molecular weight is preferably e.g., less than 2000, more preferably 1900 or less (e.g., less than 1800), and even more preferably 1500 or less, and may be 1000 or less (e.g., 500 or less). In addition, for example, when a block copolymer of EO and PO is used as a surfactant, the weight average molecular weight thereof may be, e.g., 500 or more, 1000 or more, and further 1500 or more, 2000 or more, and further 2500 or more. The upper limit of the weight average molecular weight, is e.g., less than $1 \times 10^4$, and preferably 9500 or less, and may be, e.g., less than 9000, less than 7000, or less than 5000.

As the molecular weight of the surfactant, a molecular weight calculated from a chemical formula may be employed, or a value of a weight average molecular weight derived by GPC (aqueous phase, on polyethylene glycol conversion basis) may be employed. For example, polyoxyethylene alkyl ether preferably employs a molecular weight calculated from a chemical formula, and a block copolymer of EO and PO preferably employs a weight average molecular weight derived by the GPC as described above.

Without particular limitation, in an embodiment where the polishing composition contains a surfactant, the content of the surfactant relative to 100 parts by weight of an abrasive (typically, silica particles) is, in view of cleanability and the like, usually, suitably 20 parts by weight or less, preferably 10 parts by weight or less, and more preferably 6 parts by weight or less (e.g., 3 parts by weight or less). In view of better exerting an effect of use of the surfactant, the content of the surfactant relative to 100 parts by weight of an abrasive is suitably 0.001 parts by weight or more, preferably 0.01 parts by weight or more, and more preferably 0.1 parts by weight or more, and may be 0.5 parts by weight or more.

<Water>

Examples of water in the polishing composition disclosed herein to be potentially preferably used include ion-exchanged water (deionized water), pure water, ultrapure water, and distilled water. In water to be used, the content of transition metal ions is preferably, e.g., 100 ppb or less in total, in order to avoid inhibiting a function of another component in the polishing composition as much as possible. For example, water can have improved purity by removal of impurity ions by ion-exchange resin, removal of contaminants by a filter, distillation, etc. The polishing composition disclosed herein may further contain an organic solvent that can be uniformly mixed with water (lower alcohol, lower ketone, etc.), as appropriate. In a solvent(s) in the polishing composition, water preferably accounts for 90% by volume or more, and more preferably 95% by volume or more (e.g., 99 to 100% by volume).

< Other components>

The polishing composition disclosed herein may further contain, as appropriate, a known additive that can be used for a polishing composition (e.g., a polishing composition used for a final polishing step of a silicon wafer), such as organic acid, an organic acid salt, inorganic acid, an inorganic acid salt, a chelator, an antiseptic agent, or an antifungal agent, as long as an effect of the present invention is not significantly inhibited.

The organic acid and salts thereof, and inorganic acid and salts thereof can be used singly or in combination of two or more kinds thereof. Examples of the organic acid include aliphatic acids such as formic acid, acetic acid, and propionic acid; aromatic carboxylic acids such as benzoic acid and phthalic acid; itaconic acid; citric acid; oxalic acid; tartaric acid; malic acid; maleic acid; fumaric acid; succinic acid; glycolic acid; malonic acid; gluconic acid; alanine; glycine; lactic acid; hydroxyethylidene diphosphoric acid (HEDP); organic sulfonic acid such as methanesulfonic acid; nitrilotris (methylenephosphoric acid) (NTMP); and organic phosphonic acid such as phosphonobutane tricarboxylic acid (PBTC). Examples of the organic acid salt include alkali metal salts (sodium salts, potassium salts, etc.) and ammonium salts of organic acid. Examples of the inorganic acid include hydrochloric acid, phosphoric acid, sulfuric acid, phosphonic acid, nitric acid, phosphinic acid, boric acid, and carbonic acid. Examples of the inorganic acid salt include alkali metal salts

(sodium salts, potassium salts, etc.) and ammonium salts of inorganic acid.

The chelator can be used singly or in combination of two or more kinds thereof. Examples of the chelator include aminocarboxylic acid-based chelators and organic phosphonic acid-based chelators. Preferred examples of the chelators include ethylenediamine tetrakis(methylenephosphinic acid), diethylene triamine penta(methylenephosphinic acid), and diethylene triamine pentaacetic acid. Examples of the antiseptic agent and antifungal agent include isothiazoline-based compounds, paraoxybenzoic acid esters, and phenoxyethanol.

The polishing composition disclosed herein preferably contains substantially no oxidant. This is because when the polishing composition contains an oxidant, supply of the polishing composition to a substrate (e.g., a silicon wafer) can cause oxidation on a surface of the substrate and generate an oxide layer, thereby reducing a polishing removal rate. Specific examples of an oxidant in this context include hydrogen peroxide ($H_2O_2$), sodium persulfate, ammonium persulfate, and sodium dichroloisocyanurate. The phrase that the polishing composition contains substantially no oxidant means not containing an oxidant at least intentionally. Accordingly, when inevitably containing a small amount of an oxidant (e.g., the molar concentration of an oxidant in the polishing composition is 0.0005 mole/L or less, preferably 0.0001 mole/L or less, more preferably 0.00005 mole/L or less, and particularly preferably 0.00001 mole/L or less) derived from a raw material, a product method, etc., the polishing composition can be encompassed within the concept of a polishing composition containing substantially no oxidant in this context.

<pH>

The pH of the polishing composition disclosed herein is not particularly limited, and suitable pH can be employed corresponding to a substrate, etc. In some embodiments, the pH of the polishing composition is appropriately 8.0 or more, preferably 8.5 or more, and more preferably 9.0 or more. Higher pH of the polishing composition tends to lead to increase in a polishing removal rate. Meanwhile, in view of preventing dissolution of silica particles and suppressing reduction in action of mechanical polishing, the pH of the polishing composition is usually, suitably 12.0 or less, preferably 11.0 or less, more preferably 10.8 or less, and even more preferably 10.5 or less.

In the art disclosed herein, the pH of the polishing composition can be known by performing three-point calibration with standard buffers (a phthalate pH buffer with pH 4.01 (25°C), a neutral phosphate pH buffer with pH 6.86 (25°C), and a carbonate pH buffer with pH 10.01 (25°C)) using a pH meter (e.g., a glass-electrode hydrogen ion concentration indicator (model: F-72) manufactured by Horiba, Ltd.), and then inserting a glass electrode into a composition to be measured, leaving it to stand for 2 minutes or more until stabilization and conducting measurement.

<Polishing Slurry>

The polishing composition disclosed herein is typically supplied onto a surface of a substrate in form of a polishing slurry containing the polishing composition, and used for polishing the substrate. The polishing slurry can be, e.g., prepared by diluting any of the polishing compositions disclosed herein (typically, diluting with water). Alternatively, the polishing composition may be used directly as a polishing slurry. Other examples of the polishing slurry containing the polishing composition disclosed herein include a polishing slurry formed by adjusting the pH of the composition.

The abrasive content (typically, silica particles) in a polishing slurry is not particularly limited, and is, e.g., 0.01% by weight or more, preferably 0.05% by weight or more, more preferably 0.10% by weight or more, and even more preferably 0.15% by weight or more. Increase in the abrasive content can provide a higher polishing removal rate. The content is suitably 10% by weight or less, preferably 7% by weight or less, more preferably 5% by weight or less, and even more preferably 2% by weight or less, and may be, e.g., 1% by weight or less, 0.5% by weight or less, or 0.4% by weight or less. This facilitates achieving maintenance of a surface quality.

The basic compound content of a in a polishing slurry is not particularly limited. In view of improving a polishing removal rate, the content is usually, suitably 0.0005% by weight or more, preferably 0.001% by weight or more, and more preferably 0.003% by weight or more. In view of improving a surface quality (e.g., reduction in haze), etc., the content is suitably less than 0.1% by weight, preferably less than 0.05% by weight, and more preferably less than 0.03% by weight (e.g., less than 0.025% by weight, and further, less than 0.01% by weight).

Without particular limitation, in some embodiments, the content C1 of the first water-soluble polymer (particularly, a cellulose derivative) in a polishing slurry may be, e.g., 0.0001% by weight or more, and is usually, suitably 0.0005% by weight or more, and preferably 0.001% by weight or more, and may be, e.g., 0.002% by weight or more, in view of improving a surface quality, etc. The upper limit of the content C1 of the first water-soluble polymer is not particularly limited, and can be, e.g., 0.05% by weight or less. In view of stability or a polishing removal rate, cleanability in a concentrate form, etc., the content C1 of the first water-soluble polymer in some embodiments is preferably 0.03% by weight or less, more preferably 0.015% by weight or less, and even more preferably 0.01% by weight or less. The polishing slurry disclosed herein can be prepared even in an embodiment e.g., where the content C1 of the first water-soluble polymer is 0.008% by weight or less, 0.006% by weight or less, or 0.004% by weight or less.

Without particular limitation, in some embodiments, the content C2 of the second water-soluble polymer (particularly, a polyvinyl alcohol-based polymer) in a polishing slurry may be, e.g., 0.0001% by weight or more, and is usually, suitably 0.0005% by weight or more, and preferably 0.001% by weight or more, and may be, e.g., 0.002% by weight or more, or 0.003% by weight or more in view of improving a surface quality, etc. The upper limit of the content C2 of the second water-soluble polymer is not particularly limited, and can be, e.g., 0.05% by weight or less. In view of stability or a polishing removal rate, cleanability in a concentrate form, etc., the content C2 of the second water-soluble polymer in some embodiments is preferably 0.03% by weight or less, more preferably 0.015% by weight or less, and even more preferably 0.01% by weight or less. The polishing slurry disclosed herein can be prepared even in an embodiment e.g., where the content C2 of the second water-soluble polymer is 0.008% by weight or less, 0.006% by weight or less, or 0.004% by weight or less.

Without particular limitation, in some embodiments, the content C3 of the third water-soluble polymer (particularly, a nitrogen atom-containing polymer) in a polishing slurry may be, e.g., 0.0001% by weight or more, and is usually, suitably 0.0005% by weight or more, and preferably 0.001% by weight or more, and more preferably 0.002% by weight or more, and may be 0.003% by weight or more, or 0.005% by weight or more in view of improving a surface quality, etc. The upper limit of the content C3 of the third water-soluble polymer is not particularly limited, and can be, e.g., 0.1% by weight or less. In view of stability or a polishing removal rate, cleanability in a concentrate form, etc., the content C3 of the third water-soluble polymer in some embodiments is preferably 0.05% by weight or less, more preferably 0.02% by weight or less, and even more preferably 0.01% by weight or less.

The total content (C1 + C2 + C3) of the first water-soluble polymer, the second water-soluble polymer, and the third water-soluble polymer in the polishing slurry is not particularly limited, and can be, e.g., 0.0001% by weight or more in some embodiments. In view of reduction in haze, etc., the total content is preferably 0.0005% by weight or more, more preferably 0.001% by weight or more, and even more preferably 0.002% by weight or more, and may be, e.g., 0.005% by weight or more. The upper limit of the total content is, e.g., 0.5% by weight or less, and in view of a polishing removal rate, etc., it is preferably 0.2% by weight or less, more preferably 0.1% by weight or less, and even more preferably 0.05% by weight or less (e.g., 0.02% by weight or less, and further, 0.015% by weight or less).

In an embodiment in presence of a surfactant, the content of the surfactant in a polishing slurry (the total content in presence of two or more kinds of surfactants) is not particularly limited, as long as an effect of the present invention is not significantly prevented. Usually, the content of the surfactant can be, e.g., 0.00001% by weight or more in view of cleanability, etc. In view of reduction in haze, etc., the content is preferably 0.0001% by weight or more, more preferably 0.0005% by weight or more, and even more preferably 0.001% by weight or more. In view of a polishing removal rate, etc., the content is preferably 0.1% by weight or less, more preferably 0.01% by weight or less, and even more preferably 0.005% by weight or less (e.g., 0.002% by weight or less).

<Concentrate>

The polishing composition disclosed herein may be a concentrated form (i.e., a concentrate form of a polishing slurry) before supply to a substrate. Such a concentrated form of the polishing composition is advantageous in view of convenience, cost reduction, etc. in production, distribution, storage, etc. The concentration factor is not particularly limited, can be, e.g., about 2-fold to 100-fold in volume, and is usually, suitably about 5-fold to 50-fold (e.g., about 10-fold to 40-fold). Such a concentrate can be diluted at a desired timing to prepare a polishing slurry (a working slurry), and can be used in an embodiment of supplying the polishing slurry to a substrate. The dilution can be performed, e.g., by adding water to the concentrate and mixing them.

When the polishing composition (i.e., a concentrate) is diluted and used for polishing, the abrasive content in the concentrate can be, e.g., 25% by weight or less. In view of dispersion stability, filterability, etc. of the polishing composition, the content is usually, preferably 20% by weight or less, and more preferably 15% by weight or less. In some preferred embodiments, the abrasive content may be 10% by weight or less, or 5% by weight or less. In view of convenience and cost reduction, etc. in production, distribution, storage, etc., the abrasive content in the concentrate can also be, e.g., 0.1% by weight or more, and is preferably 0.5% by weight or more, more preferably 0.7% by weight or more, and even more preferably 1% by weight or more.

In some embodiments, the content of a basic compound in the concentrate can be, e.g., less than 2% by weight. In view of storage stability, etc., the content is usually, preferably 1% by weight or less, more preferably 0.5% by weight or less, and even more preferably 0.1% by weight or less. In view of convenience, cost reduction, etc. in production, distribution, storage, etc., the content of a basic compound in the concentrate can also be, e.g., 0.005% by weight or more, preferably 0.01% by weight or more, more preferably 0.05% by weight or more, and even more preferably 0.1% by weight or more.

In some embodiments, the total content of the first water-soluble polymer, the second water-soluble polymer, and the third water-soluble polymer in the concentrate can be, e.g., 3% by weight or less. In view of filterability and cleanability of the polishing composition, etc., the content is usually, preferably 1% by weight or less, and more preferably 0.5% by

weight or less. In view of convenience, cost reduction, etc. in production, distribution, storage, etc., the content is also usually, suitably 0.001% by mass or more, preferably 0.005% by weight or more, and more preferably 0.01% by weight or more. Similarly, in an embodiment where the concentrate contains an optional water-soluble polymer in addition to the first, second, and third water-soluble polymers, the total content of water-soluble polymers in the concentrate can be set from the aforementioned range.

In an embodiment where the polishing composition contains a surfactant, the content of a surfactant in the concentrate can be, e.g., 0.25% by weight or less, preferably 0.15% by weight or less, and more preferably 0.1% by weight or less, and may be 0.05% by weight or less, or 0.025% by weight or less. The content of a surfactant in the concentrate can also be, e.g., 0.0001% by weight or more, preferably 0.001% by weight or more, more preferably 0.005% by weight or more, and even more preferably 0.01% by weight or more.

<Preparation of Polishing Composition>

The polishing composition in the art disclosed herein may be a single-agent type or a multi-agent type such as a two-agent type. For example, the composition may be configured to prepare a polishing slurry by mixing Part A, which contains at least an abrasive among components of the polishing composition, and Part B, which contains at least a part of the remaining components, and mixing and diluting them at a suitable timing, as appropriate.

A preparation method of the polishing composition is not particularly limited. For example, a well-known mixing device such as a blade stirrer, an ultrasonic disperser, or a homomixer can be used to mix each component included in the polishing composition. An embodiment of mixing these components is not particularly limited, and for example, all components may be mixed at a time or may be mixed in an order preset appropriately.

<Application>

The polishing composition disclosed herein can be applied to polishing of substrates with various material qualities and shapes. Examples of materials of the substrates include metals or semimetals such as silicon materials, aluminum, nickel, tungsten, copper, tantalum, titanium, and stainless steel, or alloys thereof; glassy substances such as quartz glass, aluminosilicate glass, and glassy carbon; ceramic materials such as alumina, silica, sapphire, silicon nitride, tantalum nitride, and titanium carbide; compound semiconductor substrate materials such as silicon carbide, gallium nitride, and gallium arsenide; and resin materials such as polyimide resins. In particular, the substrate may be formed of a plurality of materials. The shape of a substrate is not particularly limited. The polishing composition disclosed herein can be applied to polishing of a substrate having a plane that has, e.g., a plate shape or a polyhedron shape, or polishing of an end of a substrate (e.g., polishing of a wafer edge).

The polishing composition disclosed herein can be preferably used for polishing of a surface formed of a silicon material. Specific examples of the silicon material include silicon single crystal, amorphous silicon, and polysilicon. The polishing composition disclosed herein can be particularly preferably used for polishing of a surface formed of silicon single crystal (e.g., polishing of a silicon wafer).

The polishing composition disclosed herein can be preferably applied to a polishing step of a substrate (e.g., a silicon wafer). The substrate may be subjected to common treatment that can be applied to a substrate in a step upstream from a polishing step, such as lapping or etching, before a polishing step with the polishing composition disclosed herein.

The polishing composition disclosed herein is effective for use in a final step or an immediately preceding polishing step of a substrate (e.g., a silicon wafer), particularly preferably for use in a final polishing step. The final polishing step in this context refers to a last polishing step (i.e., a step preceding no further polishing) in a production process of an object of interest. The polishing composition disclosed herein may also be used for a polishing step upstream from a final polishing (that refers to a stock polishing step between a rough polishing step and a last polishing step, typically includes at least a primary polishing step, and may further include a secondary, tertiary or more-order polishing step(s)), e.g., a polishing step performed just before final polishing.

The polishing composition disclosed herein is effective in application to polishing (typically, final polishing or the preceding polishing thereof) of e.g., a silicon wafer prepared to have a surface with a surface roughness of 0.01 nm to 100 nm through an upstream step. Application to final polishing is particularly preferred. The surface roughness Ra of a substrate can be measured using e.g., the laser scanning surface roughness meter "TMS-3000WRC" manufactured by Schmitt Measurement System Inc.

<Polishing>

The polishing composition disclosed herein can be used for polishing of a substrate e.g., in an embodiment including the following operation. Description will now be made for a preferred embodiment of a method of polishing a silicon wafer as a substrate with use of the polishing composition disclosed herein.

In other words, a polishing slurry containing any of the polishing compositions disclosed herein is provided. Provision of the polishing slurry may include subjecting the polishing composition to operation such as concentration adjustment (e.g., dilution), pH adjustment, etc., thereby preparing the polishing slurry. Alternatively, the polishing composition may be directly used as a polishing slurry.

Then, the polishing slurry is supplied to a substrate, and polishing is carried out by a common method. For example, in final polishing of a silicon wafer, typically, a silicon wafer that experienced a lapping step is set in a typical polishing machine, and then the polishing slurry is supplied via a polishing pad of the polishing machine onto a surface to be polished in the silicon wafer. Typically, while the polishing slurry is consecutively supplied, a polishing pad is pushed against a surface to be polished of a silicon wafer and both are relatively moved (e.g., rotatably moved). Through such a polishing step, polishing of a substrate is completed.

A polishing pad used in the polishing step is not particularly limited. For example, polishing pads such as a foamed polyurethane type, a non-woven fabric type, and a suede type can be used. Each polishing pad may or may not contain an abrasive. Usually, a polishing pad containing no abrasive is preferably used.

A substrate polished using the polishing composition disclosed herein is typically cleaned. Cleaning can be performed using a suitable cleaning liquid. A cleaning liquid to be used herein is not particularly limited. For example, SC-1 cleaning liquid (a mixture solution of ammonium hydroxide ($NH_4OH$), hydrogen peroxide ($H_2O_2$), and water ($H_2O$)), SC-2 cleaning liquid (a mixture solution ofHCl, $H_2O_2$, and $H_2O$), etc., which are common in the art of semiconductors or the like, can be used. Temperature of a cleaning liquid can be, e.g., within the range of room temperature (typically, about 15°C to 25°C) or higher to about 90°C. In view of improving an effect of cleaning, a cleaning liquid at 50°C to 85°C can be preferably used.

As mentioned above, the art disclosed herein may include providing a method of producing a polished material including a polishing step (preferably, final polishing) by any of the aforementioned polishing methods (e.g., a method of producing a silicon wafer) and a polished material (e.g., a silicon wafer) produced by the method.

[Examples]

Several examples relating to the present invention will be described below, but the present invention is not intended to be limited to the embodiments shown in the examples. In the following description, "part" and "%" are on a weight basis unless otherwise specified.

<Preparation of Polishing Composition>

(Examples 1 to 7)

An abrasive, a basic compound, water-soluble polymers, a surfactant, and deionized water were mixed to prepare a concentrate of a polishing composition according to each example. As an abrasive, colloidal silica (average primary particle diameter: 27 nm, average aspect ratio: 1.3) was used. As a basic compound, ammonia was used. As water-soluble polymers, hydroxyethyl cellulose (HEC; first water-soluble polymer) having a Mw of about $2.8 \times 10^5$, acetalized polyvinyl alcohol (ac-PVA; second water-soluble polymer) having a Mw of about $1.0 \times 10^4$, and polyacryloylmorpholine (PACMO; third water-soluble polymer) having a Mw of about $4.7 \times 10^5$ were used. As a surfactant, a PEO-PPO-PEO block copolymer (PEO-PPO-PEO) having a Mw of about 3000 was used. The concentrate of a polishing composition thus obtained was diluted 20 times by volume ratio with deionized water, thereby providing a polishing composition according to each example containing each component with the following concentration: an abrasive of 0.175%; a basic compound of 0.005%; HEC, ac-PVA, and PACMO at the concentrations shown in Table 1; and PEO-PPO-PEO of 0.0016%.

(Example 8)

As the second water-soluble polymer, a graft copolymer that contains polyvinyl alcohol (PVA) having a saponification degree of 98.5% or more as a main chain and polyethylene oxide (PEO) as a side chain and has a Mw of $4.0 \times 10^4$ (hereinafter represented as "PVA-g-PEO") was used. The concentration of HEC was 0.00850%. Except for these, the polishing composition according to the example was prepared in the same manner as in Example 1.

(Example 9)

As the second water-soluble polymer, a butenediol-vinyl alcohol copolymer (BVOH) with a side chain having a 1,2-diol structure and a Mw of $1.0 \times 10^4$ was used. The concentration of HEC was 0.00850%. Except for these, the polishing composition according to the example was prepared in the same manner as in Example 1. The saponification

degree of the butenediol-vinyl alcohol copolymer is 98% or more.

(Example 10)

The polishing composition according to the example was prepared in the same manner as in Example 1, except for using fully saponified PVA (saponification degree: 98% or more) having a Mw of $7.0 \times 10^4$ as the second water-soluble polymer.

(Comparative Example 1)

The concentration of HEC was 0.00850%, and ac-PVA as the second water-soluble polymer and PACMO as the third water-soluble polymer were not added. Except for these, the polishing composition according to the example was prepared in the same manner as in Example 1.

(Comparative Examples 2 to 7)

The concentrations of HEC and ac-PVA were changed as shown in Table 1, and PACMO as the third water-soluble polymer was not added. Except for these, the polishing composition according to the example was prepared in the same manner as in Example 1.

(Comparative Example 8)

The concentrations of ac-PVA and PACMO were changed as shown in Table 1, and HEC as the first water-soluble polymer was not added. Except for these, the polishing composition according to the example was prepared in the same manner as in Example 1.

<Polishing of Silicon Wafer>

As a substrate, a silicon wafer was prepared by lapping and etching a commercially available silicon single crystal wafer (conduction type: P type; crystal orientation: <100>; COP (crystal originated particle: crystal defect) free) with a diameter of 300 mm that was then subjected to stock polishing under Polishing condition 1 as follows. The stock polishing was performed using a polishing slurry containing 1.0% abrasive (colloidal silica with an average primary particle diameter of 35 nm) and 0.068% potassium hydroxide in deionized water.

[Polishing Condition 1]

Polishing machine: a sheet-fed polishing machine manufactured by Okamoto Machine Tool Works, Ltd., model "PNX-332B"

Polishing load: 20 kPa
Rotation speed of platen: 20 rpm
Rotation speed of head (carrier) : 20 rpm
Polishing pad: manufactured by Nitta Dupont Incorporated, product name "SUBA400"
Supply rate of polishing slurry: 1.0 L/min
Temperature of polishing slurry: 20°C
Temperature of platen cooling water: 20°C
Polishing time: 2 mins

Using the polishing composition according to each of the examples prepared as described above as a polishing slurry, the silicon wafer after stock polishing was polished under Polishing condition 2 as follows.

[Polishing Condition 2]

Polishing machine: a sheet-fed polishing machine manufactured by Okamoto Machine Tool Works, Ltd., model "PNX-332B"
Polishing load: 20 kPa

Rotation speed of platen: 50 rpm
Rotation speed of head (carrier) : 50 rpm
Polishing pad: manufactured by Fujibo Ehime Co., Ltd., product name "POLYPAS27NX"
Supply rate of polishing slurry: 1.5 L/min
Temperature of polishing slurry: 20°C
Temperature of platen cooling water: 20°C
Polishing time: 4 mins

The polished silicon wafer was removed from the polishing machine, and cleaned with a cleaning liquid having $NH_4OH$ (29%) : $H_2O_2$ (31%) : deionized water (DIW) = 2:5.3:48 (volume ratio) (SC-1 cleaning). More particularly, a first cleaning tank equipped with an ultrasonicator was provided, then the cleaning liquid was charged in the first cleaning tank and kept at 70°C, and the polished silicon wafer was immersed in the cleaning tank for 6 minutes. Subsequently, the silicon wafer was immersed in a second cleaning tank containing ultrapure water at 25°C for 15 minutes, then immersed again in the first cleaning tank for 6 minutes, and in the second cleaning tank for 16 minutes, and dried.

<Measurement of Haze>

A surface of the cleaned silicon wafer was measured for haze (ppm) at DWO mode using a wafer testing apparatus having the product name of "Surfscan SP5" and manufactured by KLA-Tencor Corporation (current KLA Corporation). The result thus obtained was converted to a value (haze) relative to a haze value in Comparative Example 1 as 100%. A smaller value of haze indicates a higher effect to improve haze.

<Polishing Removal Rate>

A silicon wafer (conduction type: P type; crystal orientation: <100>; COP free) with a diameter of 200 mm was prepared as an object to be polished, immersed in an aqueous HF solution (HF concentration: 2%) for 60 seconds to remove an oxide layer, and polished under Polishing condition 3 as follows using a polishing composition according to each of the examples as a polishing slurry.

[Polishing Condition 3]

Polishing machine: a sheet-fed polishing machine manufactured by Okamoto Machine Tool Works, Ltd., model "PNX-322"

Polishing load: 15 kPa
Rotation speed of platen: 30 rpm
Rotation speed of head (carrier) : 30 rpm
Polishing pad: manufactured by Fujibo Ehime Co., Ltd., product name "POLYPAS275NX"
Supply rate of polishing slurry: 0.4 L/min
Temperature of polishing slurry: 20°C
Temperature of platen cooling water: 20°C
Polishing time: 10 min

The polished silicon wafer was removed from the polishing machine, immersed in a cleaning liquid with $NH_4OH$ (29%) : $H_2O_2$ (31%) : deionized water = 1:1:12 (volume ratio) for 5 minutes, and cleaned (SC-1 cleaning). Then, the wafer was immersed in deionized water with an ultrasonicater running, and dried with a spin drier.

(Evaluation)

The weight of the silicon wafer after and before polishing was measured to calculate a polishing removal rate [nm/min] from their difference in weight and the specific gravity of silicon. The results thus obtained was converted into a relative value based on the polishing removal rate in Comparative Example 1 as 100%. A larger value indicates a higher polishing removal rate. A polishing removal rate more than 100% is evaluated to indicate enhancement in a polishing removal rate.

Table 1 shows a summary and evaluation results of each of the examples. In the table, "-" indicates non-containing.

[Table 1]

Table 1

| | First water-soluble polymer | | | Second water-soluble polymer | | | Third water-soluble polymer | | | C1/(C2+C3) | Polishing removal rate [%] | Haze [%] |
|---|---|---|---|---|---|---|---|---|---|---|---|---|
| | Type | Mw | Content C1 [%] | Type | Mw | Content C2 [%] | Type | Mw | Content C3 [%] | | | |
| Example 1 | HEC | $2.8\times10^5$ | 0.00425 | ac-PVA | $1.0\times10^4$ | 0.0050 | PACMO | $4.7\times10^5$ | 0.0043 | 0.459 | 132 | 100 |
| Example 2 | | | 0.00213 | | | 0.0050 | | | 0.0064 | 0.187 | 109 | 100 |
| Example 3 | | | 0.00213 | | | 0.0050 | | | 0.0021 | 0.298 | 174 | 98 |
| Example 4 | | | 0.00213 | | | 0.0050 | | | 0.0043 | 0.230 | 128 | 99 |
| Example 5 | | | 0.00425 | | | 0.0050 | | | 0.0021 | 0.596 | 127 | 100 |
| Example 6 | | | 0.00106 | | | 0.0050 | | | 0.0021 | 0.149 | 194 | 98 |
| Example 7 | | | 0.00425 | | | 0.0025 | | | 0.0043 | 0.630 | 113 | 100 |
| Example 8 | | | 0.00850 | PVA-g-PEO | $4.0\times10^4$ | 0.0050 | | | 0.0043 | 0.919 | 108 | 100 |
| Example 9 | | | 0.00850 | BVOH | $1.0\times10^4$ | 0.0050 | | | 0.0043 | 0.919 | 124 | 100 |
| Example 10 | | | 0.00425 | PVA | $7.0\times10^4$ | 0.0050 | | | 0.0043 | 0.459 | 135 | 100 |
| Comparative Example 1 | | | 0.00850 | - | - | - | - | - | - | - | 100 | 100 |
| Comparative Example 2 | | | 0.00875 | ac-PVA | $1.0\times10^4$ | 0.0006 | - | - | - | - | 126 | 106 |
| Comparative Example 3 | | | 0.00875 | | | 0.0013 | - | - | - | - | 126 | 108 |
| Comparative Example 4 | | | 0.00875 | | | 0.0025 | - | - | - | - | 118 | 109 |
| Comparative Example 5 | | | 0.00875 | | | 0.0050 | - | - | - | - | 103 | 106 |
| Comparative Example 6 | | | 0.00425 | | | 0.0025 | - | - | - | - | 170 | 106 |
| Comparative Example 7 | | | 0.00213 | | | 0.0025 | - | - | - | - | 212 | 106 |
| Comparative Example 8 | - | - | - | | | 0.0050 | PACMO | $4.7\times10^5$ | 0.00875 | - | 96 | 99 |

As shown in Table 1, with regard to a polishing composition containing silica particles, a basic compound, and water, Examples 1 to 10, each employing a polishing composition that contains a cellulose derivative, a polyvinyl alcohol-based polymer, and a nitrogen atom-containing polymer and has a ratio (C1/(C2 + C3)) of 0.1 or more representing a ratio of the content of the first water-soluble polymer to the total content of the content C2 of a second water-soluble polymer and the content C3 of a third water-soluble polymer, maintained haze comparable with and improved in a polishing removal rate relative to Comparative Example 1, which employed a polishing composition that contains a cellulose derivative (particularly, HEC) as the only water-soluble polymer. Meanwhile, Comparative Examples 2 to 7, each employing solely two kinds of water-soluble polymers, a cellulose derivative (particularly, HEC) and a polyvinyl alcohol-based polymer (particularly, ac-PVA), as water-soluble polymers, exhibited higher haze than that of Comparative Example 1 and failed to combine a surface quality and a polishing removal rate. More specifically, the combination use of a cellulose derivative and a polyvinyl alcohol-based polymer enhanced a polishing removal rate but increased haze (Comparative Example 2), and failed to reduce haze even with increased usage of a polyvinyl alcohol-based polymer. Additionally, Comparative Example 8, which employed solely two kinds of water-soluble polymers, a polyvinyl alcohol-based polymer (particularly, ac-PVA) and a nitrogen atom-containing polymer (particularly, PACMO), as water-soluble polymers, decreased in a polishing removal rate relative to Comparative Example 1, which employed solely a cellulose derivative, and failed to combine a surface quality and a polishing removal rate.

The results demonstrate that specific three kinds of water-soluble polymers (a cellulose derivative, a polyvinyl alcohol-based polymer, and a nitrogen atom-containing polymer) in composition containing silica particles, a basic compound, and water can be selected and used at a predetermined use ratio, thereby enabling both maintenance of a high surface quality and enhancement in a polishing removal rate.

While specific examples of the present invention have been described above in detail, these are only illustrative, and do not limit the scope of the claims. The technologies recited in the claims include various modifications and alternations of the specific examples illustrated above.

## Claims

1. A polishing composition comprising silica particles as an abrasive, a basic compound, water, a cellulose derivative as a first water-soluble polymer, a polyvinyl alcohol-based polymer as a second water-soluble polymer, and a nitrogen atom-containing polymer as a third water-soluble polymer,
   wherein the ratio (C1/(C2 + C3)) of the content C1 of the first water-soluble polymer to the total content of the content C2 of the second water-soluble polymer and the content C3 of the third water-soluble polymer is 0.1 or more on a weight basis.

2. The polishing composition according to claim 1, wherein the ratio (C3/C2) of the content C3 of the third water-soluble polymer to the content C2 of the second water-soluble polymer is 0.05 or more and less than 5 on a weight basis.

3. The polishing composition according to claim 1 or 2, wherein the ratio (C3/(C1 + C2)) of the content C3 of the third water-soluble polymer to the total content of the content C1 of the first water-soluble polymer and the content C2 of the second water-soluble polymer is 0.18 or more and less than 10 on a weight basis.

4. The polishing composition according to any one of claims 1 to 3, wherein the silica particles have an average aspect ratio of 1.0 or more and 3.0 or less.

5. The polishing composition according to any one of claims 1 to 4, wherein the third water-soluble polymer has a weight average molecular weight of 50, 000 or more.

6. The polishing composition according to any one of claims 1 to 5, wherein the third water-soluble polymer is an acryloylmorpholine-based polymer.

7. The polishing composition according to any one of claims 1 to 6, wherein the content C1 of the first water-soluble polymer, the content C2 of the second water-soluble polymer, and the content C3 of the third water-soluble polymer meet the following relation on a weight basis:

$$C1 < (C2 + C3).$$

8. The polishing composition according to any one of claims 1 to 7, for use in polishing a surface comprising a silicon

material.

**9.** A concentrate of the polishing composition according to any one of claims 1 to 8.

## INTERNATIONAL SEARCH REPORT

International application No.
**PCT/JP2023/008722**

### A. CLASSIFICATION OF SUBJECT MATTER

***H01L 21/304***(2006.01)i; ***C08K 3/36***(2006.01)i; ***C08L 1/08***(2006.01)i; ***C08L 29/04***(2006.01)i; ***C08L 33/26***(2006.01)i; ***C09G 1/02***(2006.01)i; ***C09K 3/14***(2006.01)i

FI: H01L21/304 622D; H01L21/304 622C; C09K3/14 550Z; C09K3/14 550D; C09G1/02; C08L29/04 B; C08L33/26; C08L1/08; C08K3/36

According to International Patent Classification (IPC) or to both national classification and IPC

### B. FIELDS SEARCHED

Minimum documentation searched (classification system followed by classification symbols)

H01L21/304; C08K3/36; C08L1/08; C08L29/04; C08L33/26; C09G1/02; C09K3/14

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2021-57467 A (FUJIMI INC.) 08 April 2021 (2021-04-08)<br>entire text, all drawings | 1-9 |
| A | JP 2020-161603 A (FUJIMI INC.) 01 October 2020 (2020-10-01)<br>entire text, all drawings | 1-9 |
| A | JP 2020-152890 A (FUJIMI INC.) 24 September 2020 (2020-09-24)<br>entire text, all drawings | 1-9 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 April 2023** | **25 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/008722**

| Patent document cited in search report | Publication date (day/month/year) | Patent family member(s) | Publication date (day/month/year) |
|---|---|---|---|
| JP 2021-57467 A | 08 April 2021 | (Family: none) | |
| JP 2020-161603 A | 01 October 2020 | (Family: none) | |
| JP 2020-152890 A | 24 September 2020 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2022047438 A
- JP 5897200 B
- JP 6037416 B
- JP 6185432 B
- JP 6232243 B
- JP 2020013824 A